# EUROPÄISCHE PATENTSCHRIFT

(11) **EP 3 857 658 B1**
(45) Veröffentlichungstag und Bekanntmachung des Hinweises auf die Patenterteilung: **13.03.2024**
(21) Anmeldenummer: 19802105.7
(22) Anmeldetag: 05.11.2019
(51) Int. Cl.: H02B 1/28, F24F 7/003, H02B 1/56, H05K 5/02, F24F 7/02, F24F 13/08, F24F 7/00

(54) **VENTILATIONSANORDNUNG SOWIE VORRICHTUNG MIT EINER VENTILATIONSANORDNUNG**
VENTILATION ASSEMBLY AND DEVICE WITH VENTILATION ASSEMBLY
AGENCEMENT DE VENTILATION ET DISPOSITIF AVEC UN TEL AGENCEMENT

(30) Priorität: 23.11.2018 DE 102018220186
(43) Veröffentlichungstag der Anmeldung: 04.08.2021
(73) Patentinhaber: Siemens Energy Global GmbH & Co. KG, 81739 München (DE)
(72) Erfinder: MONKA, Roland, 10318 Berlin (DE); WEIGEL, Marcel, 13129 Berlin-Blankenburg (DE)
(86) Internationale Anmeldenummer: PCT/EP2019/080181
(87) Internationale Veröffentlichungsnummer: WO 2020/104182

(56) Entgegenhaltungen:
- WO-A1-2013/160070
- DE-C1- 4 313 776
- DE-T2- 68 902 437
- US-A1- 2005 022 878

## Beschreibung

Die Erfindung betrifft eine Ventilationsanordnung für ein Gehäuse aufweisend einen Ventilationskanal mit einer Mündungsöffnung und einer die Mündungsöffnung schirmenden ersten Schirmhaube, wobei der Ventilationskanal sich zu der Mündungsöffnung im Querschnitt erweitert und/oder verjüngt und die Mündungsöffnung von der ersten Schirmhaube unter Freilassung eines Spaltes umgriffen ist.

Eine Ventilationsanordnung ist beispielsweise aus der Offenlegungsschrift DE 10 2012 213 438 A1 bekannt. Dort ist ein volumenveränderliches Gehäuse beschrieben, dessen Inneres mittels eines Ventilationskanals und einer Mündungsöffnung mit der Umgebung in Verbindung steht. Die Mündungsöffnung ist von einer schirmenden Schirmhaube geschirmt.

Mittels der Schirmhaube wird die Mündungsöffnung vor einem unmittelbaren Zugang geschützt. Insbesondere bei verschiedenartigen Einbaulagen ist die Wirkung der Schirmhaube nur begrenzt wirksam. In diesen Fällen besteht die Gefahr des Eindringens beispielsweise von Fremdkörpern in die Mündungsöffnung bzw. in den Ventilationskanal. Entsprechend sind für verschiedene Einbaulagen jeweils angepasste Ventilationsanordnungen bereitzustellen oder während der Montage eine spezielle Montageposition sicherzustellen. Die Vorhaltung verschiedener Ventilationsanordnungen stellt sich als kostenintensiv dar. Die Umsetzungen spezifischer Montageanweisungen zur Erzielung bestimmter Einbaulagen hat sich als fehleranfällig erwiesen.

Aus der Patentschrift DE 43 13 776 C1 geht ein Belüftungs- und Entwässerungsstutzen für elektrotechnische Gehäuse hervor. Der dortige Stutzen weist ein becherförmiges Teil mit einem Boden auf, an welchem mehrere Krägen angeformt sind. Der internationalen Veröffentlichung WO 2013/16 0070 A1 ist für die Belüftung eines elektrischen Gerätes ein Belüftungselement entnehmbar. Dieses Belüftungselement ist aus einem Material gefertigt, welches im Falle des Erreichens einer Aktivierungstemperatur eine Belüftungskanal verschließt. Der Übersetzung der europäischen Patentschrift EP 0 353 110 B1 (DE 689 02 437 T2) ist eine Entlüftungsvorrichtung für ein Schutzgehäuse entnehmbar. Die dortige Entlüftungsvorrichtung weist einen Flansch auf, an dem Zapfen sternförmig nach außen vorspringen. Der Veröffentlichung US 2005/0022878 A1 ist eine Ventilationsstruktur entnehmbar, welche ein Eindringen von Fremdkörpern erschweren soll. Die Ventilationsstruktur weist mehrere hohlzylindrische Stutzen auf.

Für die verschiedenen Anordnungen ist jeweils eine Wirksamkeit in einer begrenzten Anzahl von Einbaulagen gegeben, wodurch deren Verwendbarkeit eingeschränkt ist.

Entsprechend ergibt sich als Aufgabe der Erfindung, eine universell verbaubare Ventilationsanordnung anzugeben.

Erfindungsgemäß wird die Aufgabe bei einer Ventilationsanordnung der eingangs genannten Art dadurch gelöst, dass die erste Schirmhaube von einer zweiten Schirmhaube umgriffen ist und außenmantelseitig am Ventilationskanal und außenmantelseitig an der zweiten Schirmhaube koaxial verlaufende Nuten angeordnet sind.

Über den Ventilationskanal der Ventilationsöffnung ist ein Austausch von Fluiden aus dem Inneren eines Gehäuses in ein anderes Gehäuse oder beispielsweise in die Umgebung usw. ermöglicht. Bevorzugt kann ein Passieren des Ventilatonskanals durch Gase, insbesondere atmosphärische Luft erfolgen. Der Ventilationskanal ist daher von einem Fluid durchströmbar und stellt einen Kommunikationsweg für ein Fluid zwischen einem Inneren des Gehäuses und einem anderen Volumen, z. B. der Umgebung, dar. Die Mündungsöffnung ist von einer Mündungskante begrenzt und stellt den Punkt dar, an welchem ein Übertritt/ ein Eintritt z. B. eines Fluides z. B. in die Umgebung/in das Gehäuse, oder in ein anderes Gehäuse usw. erfolgt.

Neben einer erwünschten Zirkulation eines Fluides könnten über die Mündungsöffnung Fremdkörper (z. B. Partikel, fremde Fluide, Fluide mit abweichendem Aggregatzustand) in das Innere des Gehäuses gelangen. Mittels der Schirmhaube wird ein Zugangspfad zu der Mündungsöffnung des Ventilationskanals verlängert, so dass ein Eintreten von Fremdstoffen (z. B. Partikel, Fluide etc.) in den Ventilationskanal bzw. die Mündungsöffnung desselben erschwert ist bzw. bevorzugt verhindert wird. Bevorzugt bildet die Schirmhaube eine Barriere an der Mündungsöffnung, so dass eine Überspannung der Mündungsöffnung durch die erste Schirmhaube erfolgt. Ein direkter z. B. linearer Zugriff auf die Mündungsöffnung ist so verhindert. Zwischen der ersten Schirmhaube und dem Ventilationskanal bildet sich bevorzugt ein Spalt, insbesondere ein Ringspalt, welcher ein Umlenken der aus der Ventilationsöffnung austretenden bzw. in die Ventilationsöffnung in die Mündungsöffnung eintretenden Fluide unterstützt. Das Umlenken sollte dabei bezogen auf eine Lotrechte der Mündungsöffnung um mindestens 180° erfolgen. Durch ein Erweitern bzw. Verjüngen, also beispielsweise ein trichterartiges oder konisches Zulaufen des Ventilationskanals kann die Strömung im Bereich der Mündungsöffnung hinsichtlich ihrer Strömungsgeschwindigkeit bzw. der Verteilung des austretenden bzw. eintretenden Fluides beeinflusst werden. Bedarfsweise kann so ein Beschleunigen oder Abbremsen in Eintritts- oder Austrittsrichtung der Mündungsöffnung befördert oder reduziert werden. Gegebenenfalls kann durch die Form der Strömung, beispielsweise eine Rotation oder eine laminare Führung durch eine Verjüngung und/oder Erweiterung beeinflusst werden. Durch einen Übergang von einer Verjüngung auf Erweiterung des Querschnittes des Ventilationskanals und umgekehrt kann auch eine Düse im Ventilationskanal gebildet sein. Insbesondere bei einer Übertragung der Querschnittsänderung auf eine äußere Mantelfläche einer den Ventilationskanal begrenzenden Wandung kann auch dieser äußere Bereich am Ventilationskanal genutzt werden, um eine Strömungsbeeinflussung zu erreichen.

Das aus dem Ventilationskanal austretende Fluid sollte bevorzugt gegen die erste Schirmhaube prallen, bzw. bei einer umgekehrten Strömung aus dem Bereich von der ersten Schirmhaube in die Mündungsöffnung übertreten. Durch die Nutzung eines Ringspaltes, d. h. ein Spalt, welcher annähernd in sich geschlossen um die Mündungsöffnung herumläuft, kann ein symmetrisches gleichmäßiges Umlenken bzw. Aufspalten des Fluidstromes aus der bzw. in die Mündungsöffnung hinein erfolgen. Bevorzugt sollte die Mündungsöffnung sowie der Ventilationskanal eine rotationssymmetrische Form aufweisen, so dass sich auch ein bevorzugt annähernd kreisringförmiger Ringspalt ergibt. Gegebenenfalls kann der Spalt auch in einzelne Segmente unterteilt werden, beispielsweise um eine stabilisierende Anordnung von Haltestreben oder ähnlichem zu ermöglichen.

Eine weitere vorteilhafte Ausgestaltung kann vorsehen, dass die erste Schirmhaube zum Umgriff der Mündungsöffnung eine zur Querschnittsänderung des Ventilationskanals im Bereich der Mündungsöffnung gegensinnig gerichtete Querschnittsänderung aufweist.

Der Querschnitt des Ventilationskanals kann sich zur Mündungsöffnung hin erweitern. Entsprechend kann bei einer gegensinnigen Querschnittsänderung die Schirmhaube zum Umgriff der Mündungsöffnung in ihrem Querschnitt eine Reduktion erfahren. Es kann auch eine Querschnittsreduktion an der Mündungsöffnung des Ventilationskanals und eine Querschnittserweiterung der ersten Schirmhaube vorgesehen sein. So kann zwischen Ventilationskanal und Schirmhaube ein Spalt gebildet sein, der bei einem Austreten von Fluid bzw. Eintreten von Fluid in den Spalt eine Ablenkung von einer Lotrechten zu der Mündungsöffnung erfährt.

Das Fluid kann so durch den Spalt treten und dabei beispielsweise gegen eine Wandung des Ventilationskanals getrieben bzw. von dieser "abgesaugt" werden. Bei einer umgekehrten Variante kann beispielsweise bei einer vorgesehenen Querschnittsreduktion des Ventilationskanals im Bereich der Mündungsöffnung eine entsprechende Querschnittserweiterung der Schirmhaube vorgesehen sein, so dass der sich bildende Ringspalt ein Aus- bzw. Eintreten von Fluid von einer Wandung des Ventilationskanals abgewandt erfolgt. Insbesondere eine Außenwandung des Ventilationskanals kann zum Anströmen oder Abströmen vorgesehen sein. Insbesondere bei der Nutzung von rotationssymmetrischen Anordnungen für den Ventilationskanal bzw. für den Spalt kann so ein allseitig radiales Austreten des Fluides bzw. ein allseitig radiales Ansaugen des Fluides um die Ventilationsanordnung herum erfolgen. Dies bietet beispielsweise Vorteile bei einer Montage, da spezifische Montagelagen aufgrund der rotationssymmetrischen Ausbildung nicht eingehalten zu werden brauchen.

Eine weitere vorteilhafte Ausgestaltung kann vorsehen, dass einander zugewandte Mündungskanten von Ventilationskanal und erster Schirmhaube einander nicht hinterschneiden.

Die Mündungsöffnung des Ventilationskanals ist von einer Mündungskante begrenzt. Der Spalt wird zumindest teilweise durch die erste Schirmhaube begrenzt. In Richtung der lotrechten Austrittsachse der Mündungsöffnung (insbesondere bezogen auf die Lage der Mündungskante) sind vorteilhafterweise die Mündungskanten von Ventilationsöffnung und Schirmhaube derart dimensioniert, dass zwischen diesen ein Spalt gebildet ist, jedoch die Mündungskanten einander nicht hintergreifen. Bei einem Zusammenfügen der Ventilationsanordnung ist so ein Zusammenfügen von erster Schirmhaube und Ventilationskanal vereinfacht. So kann durch eine Variation eines Querschnitts des Ventilationskanals bzw. der Schirmhaube eine gezielte Steuerung der Strömung von ein- und austretendem Fluid erfolgen und diese zum Ventilationskanal hin ausgerichtet oder vom Ventilationskanal fortgerichtet werden. Dabei bleibt jedoch der Spalt frei von einer Hintergreifung der ersten Schirmhaube bzw. der Mündungskante des Ventilationskanals. Somit besteht die Möglichkeit, Strömungen zu richten und auf scharfkantige oder enggradige Umlenkungen für den Strömungsweg des Fluides zu verzichten. Derartige enge Radien bzw. scharfkantige Umlenkungen stehen einer definierten Strömung des Fluides entgegen und führen zu Verwirbelungen, wodurch ein Belüften über den Ventilationskanal erschwert würde. Ziel ist es jedoch gerade, trotz einer Nutzung der ersten Schirmhaube ein möglichst widerstandsarmes Strömen des Fluides in den und aus dem Ventilationskanal zu ermöglichen und dabei eine möglichst stabile Schutzwirkung für die Mündungsöffnung durch die erste Schirmhaube sicherzustellen.

Es ist vorgesehen, dass die erste Schirmhaube von einer zweiten Schirmhaube umgriffen ist.

Die Nutzung einer ersten sowie einer zweiten Schirmhaube ermöglicht es, die erste Schirmhaube vor einer unmittelbaren Berührung zu schützen. Somit kann die zweite Schirmhaube die erste Schirmhaube beispielsweise vor einer Bewitterung oder vor schädlicher Strahlung wie UV-Strahlung schützen. Die Verwendung einer ersten sowie einer zweiten Schirmhaube gestattet weiterhin einen zweischaligen Aufbau, so dass zwischen der ersten Schirmhaube sowie der zweiten Schirmhaube ein Kanal gebildet ist, in welchem beispielsweise auch ein Fluid geleitet werden kann.

Eine weitere vorteilhafte Ausgestaltung kann vorsehen, dass die zweite Schirmhaube mit einer Wandung des Ventilationskanals verbunden ist, wobei die erste Schirmhaube vor der Mündungsöffnung schwebend an der zweiten Schirmhaube abgestützt ist.

Die zweite Schirmhaube ist vorteilhaft mit einer Wandung des Ventilationskanals verbunden. Beispielsweise kann der Ventilationskanal im Wesentlichen rotationssymmetrisch mit nahezu gleichbleibender Wandstärke in seinem Verlauf ausgebildet sein, wobei die zweite Schirmhaube an der Wandung angeschlagen ist. Vorteilhaft kann die zweite Schirmhaube außenmantelseitig an der Wandung des Ventilationskanals angeschlagen sein, so dass der Ventilationskanal von der zweiten Schirmhaube umgriffen ist. Dadurch besteht die Möglichkeit, innerhalb der zweiten Schirmhaube die erste Schirmhaube anzuordnen und die erste Schirmhaube ihrerseits an der zweiten Schirmhaube zu befestigen, wodurch die erste Schirmhaube die Mündungsöffnung freischwebend überspannen kann. Dadurch ist ein leichtes Ein- bzw. Austreten von Fluiden in bzw. aus der Mündungsöffnung des Ventilationskanals gewährleistet. Somit sind Verwirbelungen, die unerwünscht sind, beispielsweise durch Haltekonstruktionen reduziert. Die erste und die zweite Schirmhaube können dabei wiederum beabstandet zueinander angeordnet sein, so dass zwischen erster und zweiter Schirmhaube ein Kanal gebildet ist, in welchem ein bzw. ausströmendes Fluid gelenkt und geleitet werden kann. Bevorzugt kann die erste Schirmhaube auf einer von der Mündungsöffnung abgewandten Seite eine Tragkonstuktion aufweisen, beispielsweise Haltestreben, um dort mit der zweiten Schirmhaube verbunden zu sein.

Weiterhin ist vorgesehen, dass außenmantelseitig am Ventilationskanal und außenmantelseitig an der zweiten Schirmhaube koaxial verlaufende Nuten angeordnet sind.

Die Verwendung einer Nut, sowohl am Ventilationskanal als auch an der zweiten Schirmhaube ermöglicht es, Abrisskanten zur Verfügung zu stellen, an welchen beispielsweise störende Partikel oder Fluide (beispielsweise Flüssigkeiten in Gasen) abgeschieden werden können. Beispielsweise kann vorgesehen sein, dass es sich bei dem durch den Ventilationskanal strömenden Fluid um ein gasförmiges Fluid handelt, welches durch ein flüssiges Fluid verunreinigt sein könnte. In den Nuten können sich Flüssigkeiten absetzen, welche den Fluidstrom verunreinigen würden. Insbesondere von außerhalb des Ventilationskanals, also außerhalb des durch die Schirmhauben geschützten Bereiches können Verschmutzungen wie Partikel oder Flüssigkeiten zu der Mündungsöffnung zustreben. Durch die Nutzung von koaxialen Nuten außenmantelseitig, sowohl am Ventilationskanal als auch an der zweiten Schirmhaube kann so eine doppelte Barriere gebildet werden, welche ein Ableiten von Flüssigkeiten, Partikeln usw. von der Mündungsöffnung des Ventilationskanals bewirkt. Insbesondere eine koaxiale Gestaltung der Ventilationsanordnung, also bei der Nutzung eines rotationssymmetrischen Ventilationskanals, einer rotationssymmetrischen Wandung des Ventilationskanals, einer rotationssymmetrischen ersten sowie rotationssymmetrischen zweiten Schirmhaube, besteht so die Möglichkeit, unabhängig von der Einbaulage Flüssigkeiten über die Nuten ablaufen zu lassen, und zwar in unkritische Bereiche, so dass ein Eindringen von Flüssigkeiten in die Mündungsöffnung des Ventilationskanals erschwert ist. Zur Ausbildung einer Nut kann die Wandung des Ventilationskanals bzw. die Wandung der zweiten Schirmhaube jeweils eine nahezu gleichbleibende Stärke aufweisen, wobei beispielsweise durch ein Einsicken bzw. Profilieren der Wandung eine Nut gebildet ist. Es kann jedoch auch vorgesehen sein, dass eine Nut durch eine Reduzierung der jeweiligen Wandungsstärke ausgeformt wird. Durch eine Nut ist eine Rinne gebildet, welche einem Leiten, insbesondere eines flüssigen Fluides oder Partikeln dient.

Eine weitere vorteilhafte Ausgestaltung kann vorsehen, dass die erste Schirmhaube innenmantelseitig koaxial verlaufend eine Nut aufweist.

Durch die Lage der ersten Schirmhaube zwischen der Mündungsöffnung des Ventilationskanals sowie der zweiten Schirmhaube ist vorteilhaft ein innenmantelseitiges Anordnen einer Nut in der ersten Schirmhaube vorzusehen. Dadurch besteht die Möglichkeit, gegensinnig zu beispielsweise außenmantelseitig an der zweiten Schirmhaube oder an dem Ventilationskanal vorgesehenen Nuten innerhalb der zweiten Schirmhaube ein Auffangen von Partikeln, von Flüssigkeiten usw. vorzunehmen. Dadurch kann bei verschiedenartigsten Einbaulagen beispielsweise vertikal zur Austrittsrichtung der Mündungsöffnung oder schräg zur Austrittsrichtung oder über Kopf zu der Austrittsöffnung ein Ableiten bzw. Ablenken von Partikeln, Flüssigkeiten oder anderen Fremdstoffen, welche die Barriere der zweiten Schirmhaube passieren konnten, innerhalb der ersten Schirmhaube vorgenommen werden. Beispielsweise kann abtropfende Flüssigkeit in der Nut der ersten Schirmhaube aufgefangen und von der Mündungsöffnung des Ventilationskanals fortgeleitet werden. Dabei sollten die Nuten in der ersten Schirmhaube sowie an der zweiten Schirmhaube sowie an der Wandung des Ventilationskanals jeweils koaxial zueinander ausgerichtet sein. Der Querschnitt der Nuten kann dabei variieren, als vorteilhaft hat sich jedoch erwiesen, die Nuten im Querschnitt mit einem ellipsoiden Verlauf auszuformen.

Vorteilhafterweise kann vorgesehen sein, dass ein Nutgrund der Nut des Ventilationskanals in axialer Abfolge unterhalb der Nutgründe der Nuten der ersten und der zweiten Schirmhaube angeordnet ist, wobei unterhalb bezüglich der Achse der Austrittsrichtung der Mündungsöffnung des Ventilationskanals definiert ist.

Insbesondere bei einer koaxialen Anordnung der Nuten kann durch eine axiale Abfolge in Richtung der Koaxialachse ein axialer Versatz zwischen den Nuten der Schirmhauben sowie der Nut des Ventilationskanals vorgesehen sein. Bezüglich des axialen Versatzes ist vorzugsweise auf die Lage der jeweiligen Nutgründe, d. h. z. B. eines Scheitelpunktes der jeweiligen Nut unabhängig von der Wahl des Querschnittes der Nut abzustellen. Der Nutgrund der Nut des Ventilationskanals sollte dabei unterhalb der Nutgründe der Nuten des ersten sowie der zweiten Schirmhaube liegen. Dabei ist die Lage "unterhalb" bezüglich der Achse der Austrittsrichtung der Mündungsöffnung des Ventilationskanals definiert, welche vorteilhafterweise auch der Koaxialachse von koaxialen Nuten entspricht.

Weiterhin kann vorteilhaft vorgesehen sein, dass ein Nutgrund der Nut der ersten Schirmhaube in axialer Abfolge sowohl oberhalb des Nutgrundes der Nut des Ventilationskanals als auch oberhalb des Nutgrundes der Nut der zweiten Schirmhaube angeordnet ist, wobei oberhalb bezüglich der Achse der Austrittsrichtung der Mündungsöffnung des Ventilationskanals definiert ist.

Durch die Lage des Nutgrundes der ersten Schirmhaube sowohl oberhalb des Nutgrundes des Ventilationskanals als auch oberhalb des Nutzgrundes der Nut der zweiten Schirmhaube wird trotz der zwei Schirmhauben, die beabstandet zueinander angeordnet sind und in axialer Folge ausgehen von der Mündungsöffnung des Ventilationskanals, in verschiedenen Einbaulagen ein Ableiten bzw. Abgleiten von Fremdstoffen und unerwünschten Fluiden von der Mündungsöffnung erzielt. Insbesondere bei einer außenmantelseitigen Lage der Nut der ersten Schirmhaube kann so im Innern der Ventilationsanordnung eine Labyrinthstruktur erzeugt werden, welche von Labyrinthpfad zu Labyrinthpfad sich jeweils gegensinnig öffnende Nuten aufweist, so dass ein Abtropfen beispielsweise von Flüssigkeiten gewährleistet ist und diese schlussendlich von der Mündungsöffnung fortgeleitet und nach außerhalb der Ventilationsanordnung abgeleitet wird. Die zweite Schirmhaube kann zusätzlich zu der außenmantelseitigen Nut eine innenmantelseitige Nut aufweisen. Die innenmantelseitige Nut und die außenmantelseitige Nut können sich im Wesentlichen gegensinnig öffnen. Insbesondere können gegensinnige Nutflanken durch dieselbe Wandung gebildet sein, jedoch auf unterschiedlichen Seiten liegen.

Eine weitere vorteilhafte Ausgestaltung kann vorsehen, dass eine Ventilationsöffnung zumindest in einer Nutflanke einer Nut beabstandet zum jeweiligen Nutengrund der jeweiligen Nut angeordnet ist.

Eine Ventilöffnung ist eine Öffnung in einer Wandung einer Schirmhaube, die ein Hindurchtreten von Fluiden/Fremdstoffen ermöglicht. Durch die Anordnung einer Ventilationsöffnung in einer Nutflanke besteht die Möglichkeit, einerseits ein Fluid/einen Fremdstoff von außen in den Bereich der Nut übertreten zu lassen und dort andererseits im Bereich des Nutgrundes ein Ablenken bzw. Ablagern zu erzielen. So ist es beispielsweise möglich, in die Ventilationsanordnung eindringende Flüssigkeit über die Ventilationsöffnung in eine Nut zu lenken und zu leiten, dort diese fortzuleiten und gegebenenfalls über eine weitere Ventilationsöffnung nach außen bzw. in eine weitere Nut zu lenken. Damit ist trotz der Verwendung von Ventilationsöffnungen in Schirmhauben sichergestellt, dass einerseits ein Fluidstrom aus der Mündungsöffnung aus- bzw. eintreten kann, andererseits aber Partikel und Fremdstoffe in einen unkritischen Bereich eingelagert bzw. abgelagert werden. Über den Nutgrund können Partikel/Fremdstoffe zu geeigneten Ventilationsöffnungen weitergeleitet werden.

Eine weitere vorteilhafte Ausgestaltung kann vorsehen, dass im Ventilationskanal ein Filter angeordnet ist.

Ein Filter dient einem Rückhalten von Partikeln, um ein Hindurchtreten durch den Ventilationskanal zu verhindern. Je nach Filterausgestaltung kann die Durchlassfähigkeit des Filters variieren und mehr oder weniger große Partikel können zurückbehalten werden. Dieses Filter ist vorgesehen, trotz der Schirmhauben der Ventilationsanordnung in den Ventilationskanal eindringende große Partikel an einem Weiterleiten zu hindern. Das Filter kann beispielsweise in Form eines Gitters oder einer Gaze oder in ähnlichen Strukturen ausgebildet sein. Das Filter kann dabei bevorzugt in dem Bereich des Ventilationskanals liegen, in welchem die Mündungsöffnung angeordnet ist. Insbesondere kann das Filter sich in dem Bereich des Ventilationskanals erstrecken, in welchem dieser eine Querschnittsverjüngung oder Querschnittserweiterung erfährt.

Eine weitere vorteilhafte Ausgestaltung kann vorsehen, dass an einer Wandung des Ventilationskanals ein Anschlag für einen mantelseitigen Gewindegang, insbesondere außenmantelseitigen Gewindegang angeordnet ist.

Am Ventilationskanal kann ein Anschlag vorgesehen sein, um diesen beispielsweise an einem Gehäuse anstoßen zu lassen. Der Anschlag kann beispielsweise ein umlaufender Bund sein, welcher sich insbesondere außenmantelseitig um den Ventilationskanal herum erstreckt. Der Bund kann sich aus einer Wandung, welche den Ventilationskanal begrenzt, heraus erstrecken.

Am Bund kann insbesondere vorgesehen sein, dass der Ventilationskanal sich dort mit einem gleichbleibenden Querschnitt erstreckt, bzw. dass die Wandung dort einen gleichbleibenden Querschnitt aufweist. So ist es beispielsweise möglich, die Wandung des Ventilationskanals einerseits zur Begrenzung desselben zu nutzen, andererseits innen- oder außenmantelseitig auch einen Gewindegang aufzubringen, welcher im Wesentlichen koaxial zur Ausströmrichtung der Mündungsöffnung liegt. Dadurch ist es beispielsweise möglich, den Ventilationskanal durch eine Öffnung eines Gehäuses hindurchragen zu lassen und den Bund am Gehäuse abzustützen und unter Nutzung einer Gewindemutter (z. B. Überwurfmutter) ein Verschrauben der Ventilationsanordnung vorzunehmen, wobei unter Zwischenlage einer Gehäusewandung zwischen Gewindemutter und Bund ein kraftschlüssiger Verbund gebildet ist.

Eine weitere vorteilhafte Ausgestaltung kann vorsehen, dass zumindest eine der Schirmhauben am Anschlag abgestützt ist.

Der Anschlag kann aufgrund seiner mechanischen Stabilität genutzt werden, um dort zumindest eine der Schirmhauben abzustützen. Ein Abstützen einer Schirmhaube kann dabei mittelbar oder unmittelbar am Anschlag erfolgen. Der Anschlag kann beispielsweise in sich geschlossen ringförmig umlaufen, wodurch sich auch eine geeignete Möglichkeit bei einer koaxialen Ausformung einer Schirmhaube ergibt, diese ringförmig umlaufend am Anschlag anliegen zu lassen. Beispielsweise kann die Schirmhaube an dem Anschlag anstoßen, so dass z. B. am äußeren Umfang des Anschlages, insbesondere bei einer rotationssymmetrischen Ausgestaltung eine Schirmhaube an den Anschlag stößt und in diesen übergeht.

Eine weitere vorteilhafte Ausgestaltung kann vorsehen, dass in einem Stoß zwischen einer Schirmhaube und dem Anschlag zumindest eine Ventilationsöffnung angeordnet ist.

An einem Stoß zwischen dem Anschlag sowie der Schirmhaube kann sich geeignet eine Ventilationsöffnung erstrecken. Im Bereich des Stoßes kann zwischen Schirmhaube und Anschlag eine Rinne bzw. eine Mulde gebildet werden, in welcher sich beispielsweise Partikel oder Flüssigkeiten sammeln. Insbesondere kann vorgesehen sein, dass die im Bereich der Stoßstelle sich bildende Rinne formkomplementär zu einer in der jeweils anstoßenden Schirmhaube angeordnete Nut erstreckt. Beispielsweise kann eine Nut in der anstoßenden Schirmhaube außenmantelseitig angeordnet sein, wobei eine Nutflanke dieser Nut in einer Wandung liegt, die innenmantelseitig im Bereich des Stoßes die Rinne begrenzt. Die Rinne kann weiterhin von dem Anschlag begrenzt sein. Insbesondere in einem Rinnenboden kann sich eine Ventilationsöffnung erstrecken.

Unabhängig von der Lage einer Ventilationsöffnung kann vorteilhaft eine Nutzung mehrerer Ventilationsöffnungen vorgesehen sein, die beispielsweise insbesondere bei einer koaxial bzw. in sich geschlossenen Formgebung einer Nut bzw. einer Rinne verteilt in dieser angeordnet sind. Somit besteht die Möglichkeit, den Weg, den beispielsweise ein Partikel zum Fortleiten aus der Rinne bzw. dem Stoß zurückzulegen hat, zu verkürzen. Des Weiteren können so verschiedene Einbaulagen realisiert werden, da stets ein kurzwegiges Ableiten bzw. Ablenken eines Partikels oder auch einer Flüssigkeit aus einem Stoß oder einer Nut ermöglicht ist.

Eine weitere vorteilhafte Ausgestaltung kann vorsehen, dass die Ventilationsanordnung additiv gefertigt ist.

Unter einem additiven Fertigen wird im Sinne dieser Anmeldung die Nutzung eines schichtweisen Aufbaus der Ventilationsanordnung verstanden. Somit ist es beispielsweise möglich, eine einstückige Ventilationsanordnung auszubilden, welche im Innern der zweiten Schirmhaube die Struktur der ersten Schirmhaube aufweist und dort innenseitig Ventilationsöffnungen, Kanäle usw. ausbildet. Insbesondere die Ausbildung eines Filters im Verlauf des Ventilationskanals ermöglicht eines effizientes Nutzen einer additiven Fertigung. Die Ventilationsanordnung kann beispielsweise aus elektrisch leitfähigem Material gebildet sein.

Eine weitere vorteilhafte Ausgestaltung kann vorsehen, dass die Ventilationsanordnung UV-stabil ist.

Durch die Ausbildung einer UV-stabilen Ventilationsanordnung ist diese dafür geeignet, auch im Freiluftbetrieb, z. B. unter Sonneneinwirkung verwendet zu werden. Dabei kann einerseits das Material, aus welchem die Wandungen der Ventilationsanordnungen ausgebildet sind, selbst UV-stabil sein, beispielsweise ein UV-stabiler Kunststoff. Es kann jedoch auch vorgesehen sein, dass eine zusätzliche Beschichtung bzw. Überdeckung der Ventilationsanordnung erfolgt, so dass diese vor unmittelbarer Einwirkung von UV-Strahlung geschützt ist.

Eine weitere Aufgabe der Erfindung ist es, einen geeigneten Ort zur Verwendung einer erfindungsgemäßen Ventilationsanordnung anzugeben. Erfindungsgemäß wird die Aufgabe bei einer Vorrichtung, insbesondere einem Schaltschrank aufweisend ein geschlossenes Gehäuse mit einer Gehäusewand, dadurch gelöst, dass die Gehäusewand von einer Ventilationsanordnung gemäß einer der vorstehenden Ausführungen durchsetzt ist.

Eine Vorrichtung, insbesondere ein Schaltschrank weist ein entsprechendes Gehäuse auf, das in seinem Inneren bevorzugt elektrische Komponenten wie Klemmen, Schalter, elektrische Leitungen usw. aufweist, wobei das Innere des Schaltschrankes einerseits verschlossen ist, um einen unmittelbaren Zugang zu verhindern, jedoch andererseits das Innere des Gehäuses mit der Umgebung des Gehäuses eine fluide Kommunikation aufweist, um beispielsweise Feuchtigkeit aus dem Inneren der Vorrichtung, insbesondere des Gehäuses abzuführen. Bei der Vorrichtung kann es sich insbesondere um einen Schaltschrank handeln, d. h. im Inneren des Schaltschrankes sind Baugruppen angeordnet, um Vorrichtungen elektrisch oder pneumatisch oder in anderer Weise zu steuern. Beispielsweise können so elektrische Schaltanlagen und Schaltgeräte betätigt werden. Innerhalb eines Schaltschrankes kann jedoch auch eine Antriebseinrichtung positioniert werden, die beispielsweise eine Bewegungsenergie abgibt, indem diese aus einer anderen Energie, beispielsweise zwischengespeicherter elektrischer Energie oder mechanischer Energie gewandelt wird. Beispielsweise kann in der Vorrichtung ein Federspannmotor angeordnet sein, welcher dort einem Spannen einer Feder dient und dazu elektrisch angesteuert wird.

Die Gehäusewand kann beispielsweise eine Öffnung aufweisen, in welche die Ventilationsanordnung hineinragt und diese beispielsweise mit einem Anschlag an einer eine Öffnung umgebenden Gehäusewand zur Anlage kommt und unter Nutzung einer Verschraubung mit der Gehäusewand verschraubt ist. Aufgrund der erfindungsgemäßen Ausgestaltung der Ventilationsanordnung kann das Gehäuse in verschiedensten Lagen nunmehr montiert werden. Unabhängig von der Lage des Gehäuses schützt die Ventilationsanordnung vor einem unerwünschten Eindringen von Fremdkörpern, wie Partikeln und Flüssigkeiten usw., in das Innere des Gehäuses.

Im Folgenden wird ein Ausführungsbeispiel der Erfindung schematisch in einer Zeichnung gezeigt und nachfolgend näher beschrieben. Dabei zeigt die
- Figur 1:: einen Querschnitt durch eine Ventilationsanordnung; die
- Figur 2:: eine perspektivische Ansicht der aus Figur 1 bekannten Ventilationsanordnung im Schnitt; die
- Figur 3:: die Ventilationsanordnung im Schnitt in einer Einbaulage; die
- Figur 4:: die Ventilationsanordnung im Schnitt in einer aufrechten Einbaulage; die
- Figur 5:: die Ventilationsanordnung im Schnitt in einer schrägen Einbaulage; die
- Figur 6:: die Ventilationsanordnung im Schnitt in einer horizontalen Einbaulage; die
- Figur 7:: die Ventilationsanordnung im Schnitt in einer schrägen Einbaulage über Kopf sowie die
- Figur 8:: die Ventilationsanordnung in einer Einbaulage über Kopf.

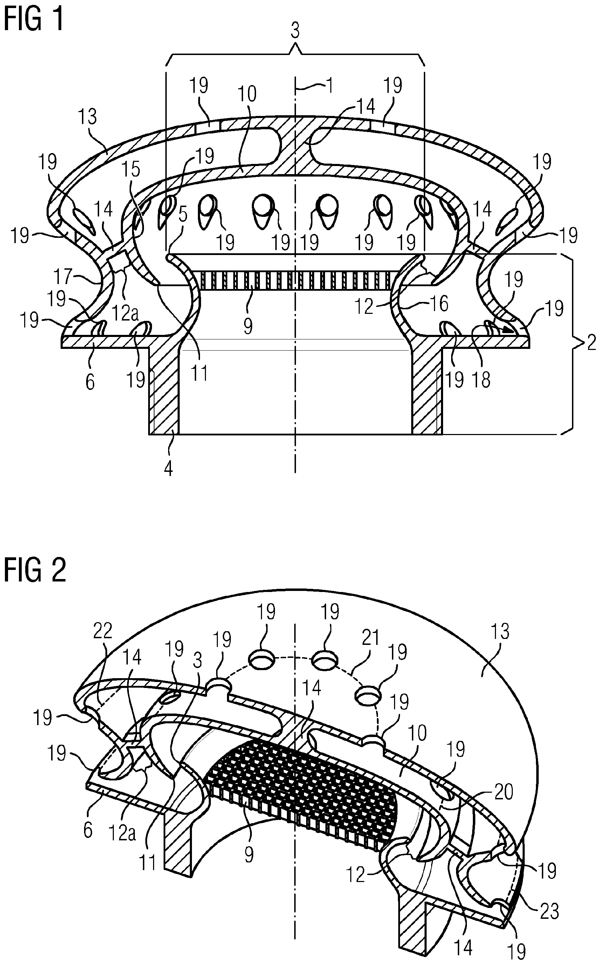

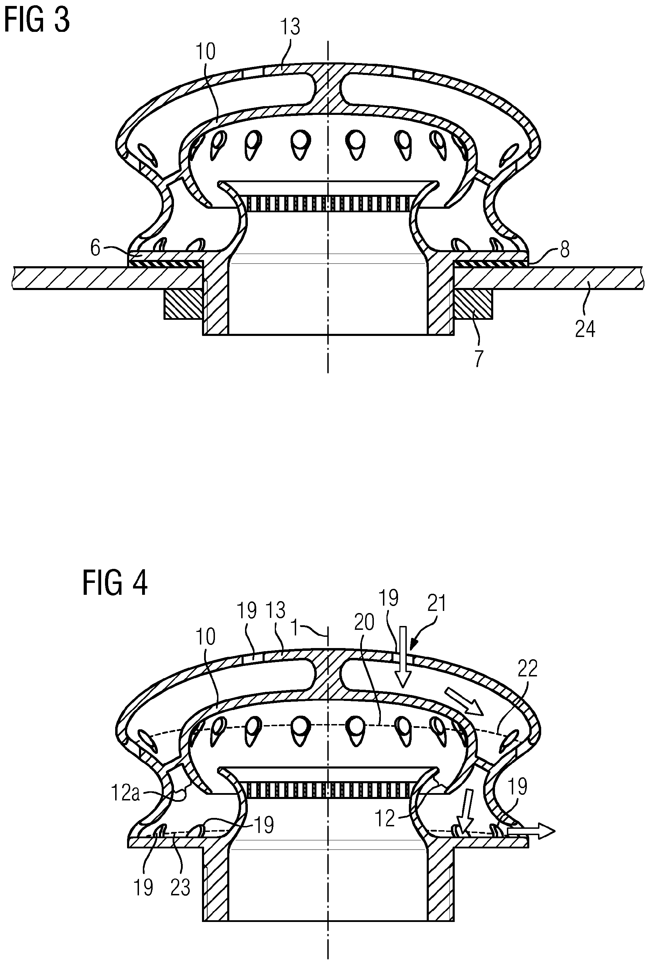

Die in der Figur 1 gezeigte Ventilationsanordnung ist im Wesentlichen rotationssymmetrisch zu einer Rotationsachse 1 ausgeformt. Koaxial zu der Rotationsachse 1 ist ein rotationssymmetrischer Ventilationskanal 2 angeordnet. Der Ventilationskanal 2 weist dabei einen rotationssymmetrischen Abschnitt auf, welcher sich im Bereich einer Mündungsöffnung 3 im Querschnitt erweitert. Dazu ist der Ventilationskanal 2 mit einer Reduzierung der Stärke einer Wandung 4 versehen. Ausgehend von einem zylindrischen Abschnitt des Ventilationskanals 2 ist dieser längs der Rotationsachse 1 in Richtung der Mündungsöffnung 3 zunächst mit einer Querschnittsverjüngung versehen, um anschließend eine Erweiterung zu erfahren. Die Mündungsöffnung 3 ist dabei von einer Mündungskante 5 begrenzt. Die Mündungskante 5 ist vorliegend kreisringförmig ausgebildet und bildet den Abschluss des sich erweiternden Querschnitts des Ventilationskanals 2. Am Übergang vom zylindrischen Abschnitt des Ventilationskanals 2 auf den querschnittsreduzierten bzw. -erweiterten Abschnitt des Ventilationskanals 2 ist ein Anschlag 6 angeordnet. Der Anschlag 6 ist dabei im Wesentlichen kreisringförmig außenmantelseitig um den Ventilationskanal 2 herum angeordnet und bildet einen bündig anliegenden Verbund zur Wandung des Ventilationskanals 2 aus. Außenmantelseitig auf der Wandung des Ventilationskanals 2, welche den hohlzylindrischen Abschnitt umgibt, ist ein Gewindegang angeordnet. Auf dem Gewindegang kann eine Überwurfmutter 7 aufgeschraubt werden (vgl. Figur 3). Der Abschnitt des Ventilationskanals 2, welcher den Gewindegang trägt, kann durch eine Öffnung einer Wandung hindurch gesteckt werden, wobei durch den Anschlag 6 die Eintauchtiefe begrenzt ist. Durch Aufschrauben der Überwurfmutter 7 und gegebenenfalls einer Verwendung einer Dichtung 8 (vgl. Figur 3) kann die Ventilationsanordnung beispielsweise an einer Gehäusewandung verschraubt und festgelegt werden. Der Ventilationskanal 2 durchsetzt die Gehäusewandung, in welche die Ventilationsanordnung eingesetzt ist. Weiterhin ist innerhalb des Ventilationskanals 2 ein Filter 9 angeordnet. Das Filter 9 ist vorliegend in Form eines Gitters im Wesentlichen lotrecht zur Rotationsachse innerhalb des Ventilationskanals 2 angeordnet (vgl. Figur 2). Durch das Filter 9 wird eine Passage von groben Partikeln durch den Ventilationskanal 2 hindurch verhindert.

Beabstandet von der Mündungsöffnung 3, die Mündungsöffnung 3 schirmend und vor dieser schwebend, ist eine erste Schirmhaube 10 positioniert. Die erste Schirmhaube 10 weist eine im Wesentlichen rotationsförmige Struktur auf, wobei die Wandung der ersten Schirmhaube 10 im Wesentlichen in Richtung der Mündungsöffnung 3 zeigend konkav gekrümmt ausgebildet ist. Dabei ist die Mündungskante 11, welche die haubenförmige Struktur abschließt, mit einem größeren Querschnitt versehen als die Mündungskante 5 der Mündungsöffnung 3 des Ventilationskanals 2. Entsprechend ist die erste Schirmhaube 10 unter Ausbildung eines Ringspaltes 12 in Richtung der Rotationsachse 1 über die Mündungskante 5 der Mündungsöffnung 3 des Ventilationskanals 2 gesetzt. Zwischen den Mündungskanten 5, 11 des Ventilationskanals 2 bzw. der ersten Schirmhaube 10 ist ein Ringspalt 12 gebildet, wobei der Ringspalt 12 selbst frei von Querungen wie Stegen oder ähnlichem ist. Dies wird dadurch erzielt, dass die erste Schirmhaube 10 vor der Mündungsöffnung 3 freischwebend angeordnet ist. Aufgrund der Querschnittserweiterung im Bereich der Mündungsöffnung 3 des Ventilationskanals 2 sowie der Querschnittsreduktion der ersten Schirmhaube 10 im Bereich der Mündungskante 11 sind die den Ringspalt 12 begrenzenden Wandungsabschnitte der ersten Schirmhaube 10 bzw. des Ventilationskanals 2 aufeinander zulaufend ausgerichtet, d. h. im Wesentlichen parallel ausgerichtet. Entsprechend ist der Ringspalt 12 radial zur Rotationsachse 1 angeordnet, wobei jedoch eine Richtwirkung am Ringspalt 12 durch die begrenzenden Wandungsabschnitte abweichend von der Richtung der Rotationsachse 1 erzwungen ist. Im vorliegenden Falle kann so aus dem Ventilationskanal 2 über die Mündungsöffnung 3 austretendes Fluid gegen die erste Schirmhaube 10 strömen, von dort umgelenkt in Richtung des Ringspaltes 12 strömen und dort außenmantelseitig gegen die Wandung des Ventilationskanals 2 strömen. Somit erfolgt ein Umlenken des Fluidstromes um zumindest 180°, insbesondere >180°.

Die Mündungskante 5 der Mündungsöffnung 3 des Ventilationskanals 2 sowie die Mündungskante 11 der ersten Schirmhaube 10 sind dabei derart im Querschnitt dimensioniert, dass ein freies Übergreifen bzw. gedachtes Bewegen der ersten Schirmhaube 10 relativ zum Ventilationskanal 2 in Richtung der Rotationsachse 1 ermöglicht ist. Mit anderen Worten die Mündungskanten 5, 11 der Mündungsöffnung 3 des Ventilationskanals 2 bzw. der ersten Schirmhaube 10 sind derart dimensioniert, dass die Mündungskante 11 der ersten Schirmhaube 10 zumindest denselben Querschnitt aufweist wie die Mündungskante 5 der Mündungsöffnung 3 des Ventilationskanals 2. Bevorzugt ist die Mündungskante 11 der ersten Schirmhaube 10 mit einem größeren Querschnitt versehen als die Mündungskante 5 der Mündungsöffnung 3 des Ventilationskanals 2.

Beabstandet zur ersten Schirmhaube 10 ist eine zweite Schirmhaube 13 derart angeordnet, dass die erste Schirmhaube 10 sowie die zweite Schirmhaube 13 eine zweischalige Schirmung der Mündungsöffnung 3 des Ventilationskanals 2 sicherstellen. Die zweite Schirmhaube 13 weist dazu einen im Wesentlichen rotationssymmetrischen Aufbau auf, wobei eine konvex gestaltete Wandung der ersten Schirmhaube 10 einer im Wesentlichen konkav gestalteten Wandung der zweiten Schirmhaube 13 zugewandt ist. Dabei erstreckt sich bezüglich der Mündungsöffnung 3 der konvex geformte Wandungsabschnitt der ersten Schirmhaube 10 auf der von der Mündungsöffnung 3 abgewandten Seite, wobei sich der konkav gekrümmte Wandungsabschnitt der zweiten Schirmhaube 13 der Mündungsöffnung 3 des Ventilationskanals 2 zugewandt ist. Zwischen den konvex und konkav geformten Wandungsabschnitten der ersten Schirmhaube 10 sowie der zweiten Schirmhaube 13 ist ein Kanal begrenzt. Der Kanal ist von Stegen 14 durchsetzt, mittels welchen die erste Schirmhaube 13 an der zweiten Schirmhaube 14 abgestützt ist, so dass die erste Schirmhaube 10 freischwebend vor der Mündungsöffnung 3 des Ventilationskanals 2 positioniert werden kann. Aufgrund der Krümmung der ersten Schirmhaube 10 ist innenmantelseitig in der ersten Schirmhaube 10 eine koaxial zur Rotationsachse 1 umlaufende Nut 15 gebildet. Die Nut 15 weist im Bereich ihrer größten radialen Erstreckung einen Nutgrund auf, von welchem sich Nutflanken erheben, um den Nutgrund zu begrenzen. Eine der Nutflanken der Nut 15 der ersten Schirmhaube 10 erstreckt sich bis zur Mündungskante 11 der ersten Schirmhauben 10.

Außenmantelseitig in einer Wandung des Ventilationskanals 2 ist eine weitere radial umlaufende Nut 16 angeordnet. Die Nut 16 ist durch die Formgebung der Wandung des Ventilationskanals 2 gebildet, wobei ein Nutgrund im Bereich einer Querschnittsreduktion des Ventilationskanals 2 angeordnet ist. Ausgehend vom Nutgrund ergeben sich Nutflanken, wobei die eine Nutflanke sich bis zur Mündungskante 5 der Mündungsöffnung 3 des Ventilationskanals 2 erstreckt. Die andere Nutflanke geht in den Anschlag 6, welcher hier vollständig ringförmig um den Ventilationskanal 2 umlaufend ausgebildet ist, über. Entsprechend ist im Schnitt ein im Wesentlichen S-förmiger Verlauf der Nuten 15, 16 der ersten Schirmhaube 10 sowie des Ventilationskanals 2, unterbrochen durch den Ringspalt 12, gegeben. Bezogen auf die Rotationsachse 1 ist dabei der Nutgrund der Nut 15 des ersten Schirmhaube 10 vor der Mündungsöffnung 3 des Ventilationskanals 2 angeordnet. Der Nutgrund der weiteren Nut 16 des Ventilationskanals 2 liegt, bezogen auf die Rotationsachse, unterhalb des Nutgrundes der Nut 15 der ersten Schirmhaube 10.

Die zweite Schirmhaube 13 weist an ihrem äußeren Umfang eine Nut 17 auf. Die Nut 17 ist koaxial zu den Nuten 15, 16 des Ventilationskanals 2 bzw. der ersten Schirmhaube 10 angeordnet. Mit ihrem Nutgrund und den Nutflanken öffnet die Nut 17 sich aufgrund ihrer außenmantelseitigen Anordnung analog zur weiteren Nut 16 außenmantelseitig in der Wandung des Ventilationskanals 2. Dabei ist der Nutgrund derart positioniert, dass von ihm ausgehende Nutflanken sich einerseits bis zum Anschlag 6, d. h. bis zum äußeren Umfang des Anschlages 6 erstrecken, so dass zwischen der zweiten Schirmhaube 13 sowie dem Anschlag 6 ein Stoß 18 gebildet ist. Der Durchmesser des Nutgrundes der Nut 17 der zweiten Schirmhaube 13 ist dabei bevorzugt mit zumindest dem gleichen Durchmesser wie der Nutgrund der Nut 15 der ersten Schirmhaube 10 versehen. Bevorzugt ist dieser Durchmesser größer. Dabei ist der Nutgrund bezüglich seiner Lage zur Nut 15 der ersten Schirmhaube 10 sowie der weiteren Nut 16 am Ventilationskanal 2 derart positioniert, dass in Richtung der Rotationsachse der Nutgrund der Nut 17 der zweiten Schirmhaube 13 zwischen dem Nutgrund der Nut 15 der ersten Schirmhaube 10 und dem Nutgrund der Nut 16 des Ventilationskanals 2 positioniert ist.

Im Bereich der Nut 17 der zweiten Schirmhaube 13 ist zwischen der zweiten Schirmhaube 13 sowie der ersten Schirmhaube 10 ein weiterer Ringspalt 12a gebildet. Der Ringspalt 12 zwischen der Mündungskante 5 des Ventilationskanals 2 sowie der ersten Schirmhaube 10 sowie der weitere Ringspalt 12a zwischen der Mündungskante 11 der ersten Schirmhaube 10 sowie der außen umgreifenden zweiten Schirmhaube 13 sind dabei von jeweils abweichend ausgerichteten Wandungen begrenzt. D. h. der Ringspalt 12 zwischen der Mündungskante 5 der Mündungsöffnung 3 des Ventilationskanals 2 und der Mündungskante 11 der ersten Schirmhauben 10 ist von gegensinnig ausgerichteten Mündungskanten 5, 11 begrenzt, wo hingegen der weitere Ringspalt 12a zwischen der ersten Schirmhaube 10 sowie der zweiten Schirmhaube 13 zwischen gleichsinnig ausgerichteten Mündungskanten 11 angeordnet ist. Dabei ist die Mündungskante 11 der Mündungsöffnung der ersten Schirmhaube 10 sowohl zur Begrenzung des Ringspaltes 12 zur Mündungskante 5 des Ventilationskanals 2 als auch zur Begrenzung des weiteren Ringspaltes 12a zur zweiten Schirmhaube 13 hin genutzt. Die Ringspalte 12, 12a sind dabei im Wesentlichen koaxial angeordnet, wobei die Richtwirkungen durch die sie begrenzenden Wandungen jeweils von einer Lotrechten abweichen und hier bevorzugt winklig zu der Rotationsachse 1 hin ausgerichtet sind.

Um einen Übertritt bzw. ein Abtropfen von in den Nuten 15, 16, 17 eintretenden Fremdstoffen wie Flüssigkeiten zu ermöglichen, sind sowohl in der ersten Schirmhaube 10 als auch in der zweiten Schirmhaube 13 Ventilationsöffnungen 19 angeordnet. Die Ventilationsöffnungen 19 sind dabei im Wesentlichen jeweils auf einer Kreisbahn verteilt angeordnet. So ist die erste Schirmhaube 10 von Ventilationsöffnungen 19 auf einer ersten Kreisbahn 20 durchsetzt. Die zweite Schirmhaube 13 ist von Ventilationsöffnungen 19 auf einer zweiten Kreisbahn 21 durchsetzt. Weiter ist die zweite Schirmhaube 13 von Ventilationsöffnungen 19, die auf einer dritten Kreisbahn 22 angeordnet sind, durchsetzt. Die zweite Schirmhaube 13 ist darüber hinaus zumindest teilweise von Ventilationsöffnungen 19 durchsetzt, die auf einer vierten Kreisbahn 23 angeordnet sind.

Auf den Kreisbahnen 20, 21, 22, 23 sind jeweils Ventilationsöffnungen 19 verteilt angeordnet. Die Ventilationsöffnungen 19 weisen bevorzugt einen kreisförmigen Querschnitt auf und erstrecken sich jeweils durch eine Wandung der ersten oder der zweiten Schirmhaube 10, 13. Über die Ventilationsöffnungen 19, die auf der zweiten Kreisbahn 21 liegen, sind Öffnungen in die zweite Schirmhaube 13 eingebracht. Über die Öffnungen können Gase oder Flüssigkeiten durch eine Wandung der zweiten Schirmhaube 13 hindurchtreten. Somit ist eine Kommunikation zwischen dem äußeren der zweiten Schirmhaube 13 sowie dem zwischen erster und zweiter Schirmhaube 10, 13 gebildeten Kanal ermöglicht. Die Ventilationsöffnungen 19 auf der zweiten Kreisbahn 21 ermöglichen dabei im Wesentlichen einen Hindurchtritt von einer Flüssigkeit oder einem Gas oder einem Partikel parallel zur Rotationsachse 1. Der Durchmesser der zweiten Kreisbahn 21 ist dabei kleiner als der Durchmesser der ersten Kreisbahn 20 mit den entsprechend darauf verteilt liegenden Ventilationsöffnungen 19, welche eine Wandung der ersten Schirmhaube 10 durchsetzen. Die erste Kreisbahn 20 ist dabei in einer Nutflanke der Nut 15 angeordnet, so dass bei einem Hindurchtreten eines Fluides oder eines Partikels, welches in der Nut 15 zum Liegen gelangt, möglich ist. Bevorzugt ist der Durchmesser der ersten Kreisbahn 20 dazu größer als der Durchmesser der Mündungskante 5 der Mündungsöffnung 3 des Ventilationskanals 2.

Die dritte Kreisbahn 22 erstreckt sich auf einem Wandungsabschnitt der zweiten Schirmhaube 13. Die dritte Kreisbahn 22 ist dabei in einer ersten Nutflanke der Nut 17, der zweiten Schirmhaube 13 angeordnet. In einer zweiten Nutflanke der Nut 17 ist die vierte Kreisbahn 23 mit Ventilationsöffnungen 19 angeordnet. Die vierte Kreisbahn 23 ist dabei derart angeordnet, dass innerhalb des Stoßes 18 Ventilationsöffnungen 19 in der zweiten Schirmhaube 13 befindlich sind, welche auch von dem Anschlag 6 begrenzt sind. Dadurch ist der Stoß 15 von Ventilationsöffnungen 19 durchsetzt.

Der Durchmesser der vierten Kreisbahn 23 weist dabei annähernd den gleichen Durchmesser auf wie die dritte Kreisbahn 22, wobei die vierte Kreisbahn 23 auch größer sein kann als die dritte Kreisbahn 22. Sowohl die dritte Kreisbahn 22 als auch die vierte Kreisbahn 23 weisen einen größeren Durchmesser auf als die zweite Kreisbahn 21 sowie die erste Kreisbahn 20.

Neben einer Positionierung der Ventilationsöffnungen 19 auf Kreisbahnen 20, 21, 22, 23 können diese auch abweichend davon positioniert sein. Bevorzugt sollte jedoch vorgesehen sein, dass jeweilige Ventilationsöffnungen 19 verteilt um die Rotationsachse 1 herum angeordnet sind, so dass bei verschiedenen Einbaulagen auch stets in der Nähe eines Tiefpunktes oder eines Hochpunktes eine Ventilationsöffnung 19 zur Lage kommt. Darüber hinaus können die Ventilationsöffnungen 19 auch auf abweichenden Bahnen angeordnet sein. In jedem Falle sollte jedoch dafür Sorge getragen werden, dass ein unmittelbarer Durchtritt von einer Ventilationsöffnung 19 einer Schirmhaube 10, 13 zu einer Ventilationsöffnung 19 einer anderen Schirmhaube 13, 10 gesperrt ist, so dass durch eine Ventilationsöffnung 19 durchtretendes Fluid oder ein Partikel gegen eine Wandung prallt und eine Umlenkung erfährt.

Vorteilhaft ist eine Ventilationsanordnung wie in den Figuren gezeigt UV-beständig ausgeführt. Die Ventilationsanordnung kann bevorzugt aus einem metallischen Werkstoff gebildet werden. Beispielsweise können die Schirmhauben 10, 13 sowie der Ventilationskanal 2 sowie der Anschlag 6 als diskrete Baugruppen ausgeformt werden, woraufhin diese unter Verwendung von Befestigungsmitteln beispielsweise von Stegen, Schrauben, Bolzen oder Klebeverbindungen zu einem winkelstarren Verbund einer Ventilationsanordnung zusammengefügt werden. Darüber hinaus kann auch vorgesehen sein, dass die Ventilationsanordnung durch ein additives Fertigungsverfahren hergestellt wird. Ein additives Fertigungsverfahren bewirkt bevorzugt einen langenweisen Aufbau der Ventilationsanordnung. Dadurch ist die Möglichkeit gegeben, final eine einstückige, massearme Ventilationsanordnung zu bilden. Als Material für die Ventilationsanordnung können neben metallischen Werkstoffen auch elektrisch isolierende Werkstoffe wie Kunststoffe, Porzellane usw. Verwendung finden. Unabhängig von der gewählten Materialart kann vorteilhaft vorgesehen sein, dass die Ventilationsanordnung, insbesondere in einem äußeren Bereich, d. h. insbesondere im Bereich der zweiten Schirmhaube 13 sowie des Anschlages 6 aus UV-beständigem Material gefertigt ist.

Die Figur 2 zeigt die aus der Figur 1 bekannte Ventilationsanordnung mit derselben Schnittebene, jedoch in einer perspektivischen Darstellung. Erkennbar wird nunmehr die Struktur des Filters 9, welche vorteilhaft im Rahmen eines additiven Fertigungsverfahrens innerhalb des Ventilationskanals 2 eingebracht wird. In der perspektivischen Darstellung wird weiterhin deutlich, dass die jeweils innerhalb der ersten bzw. zweiten Schirmhaube 10, 13 angeordneten Ventilationsöffnungen 19 derart ausgerichtet sind, dass diese in lotrechter Durchtrittsrichtung jeweils vor bzw. hinter einer Wand, z. B. einer Schirmhaube (z. B. erste Schirmhaube 10) oder des Anschlages 6 oder der Wandung 4 des Ventilationskanals 2 liegen. Dadurch ist ein direkter Durchtritt durch mehrere Wandungen hindurch erschwert.

In der Figur 3 ist die aus der Figur 1 bekannte Schnittdarstellung im montierten Zustand gezeigt. In einer Gehäusewand eines Gehäuses 24 ist eine Ausnehmung eingebracht, in welche formkomplementär der Ventilationskanal 2 eingesetzt ist. Um den Anschlag 6 herum ist eine Dichtung 6 angeordnet, welche ringförmig zwischen Anschlag 6 sowie der Gehäusewand des Gehäuses 24 liegt. Mittels der Überwurfmutter 7 ist der Anschlag 6 unter Zwischenlage der Dichtung 8 gegen die Gehäusewand verspannbar, wobei eine Komprimierung der Dichtung 8 erfolgt, so dass ein unerwünschtes Hindurchtreten einer Flüssigkeit oder eines Partikels im Bereich des Außenmantels des Ventilationskanals 2 verhindert ist. Über die Ventilationsöffnungen 19 sowie die im Innern der zweiten Schirmhaube 13 befindlichen Strömungswege bis zu der Mündungsöffnung 3 und dem dort angeordneten Filter 9 ist eine Kommunikation des Inneren des Gehäuses 24 durch die Gehäusewand mit der Umgebung ermöglicht.

In den Figuren 4 bis 8 sind verschiedene Einbaulagen der Ventilationsanordnung gezeigt, wobei jeweils beispielhaft mittels Pfeilen ein Ableitweg von Partikeln oder Flüssigkeiten gezeigt ist.

Die Figur 4 zeigt eine vertikale Ausrichtung der Rotationsachse 1. Entsprechend können Partikel, welche durch Ventilationsöffnungen 19 der zweiten Kreisbahn 21 eintreten, auf der äußeren Mantelfläche der ersten Schirmhaube 10 und über den Kanal zwischen der ersten Schirmhaube 10 sowie der zweiten Schirmhaube 13 durch den weiteren Ringspalt 12a bis zu dem Anschlag 6 abgleiten. Die weitere Nut 16 verhindert ein Eindringen in den Ventilationskanal 2. Über die Ventilationsöffnungen 19 der vierten Kreisbahn 23 können unerwünschte Fremdstoffe wie Partikel oder Flüssigkeiten nach außen herabtropfen bzw. herausfallen.

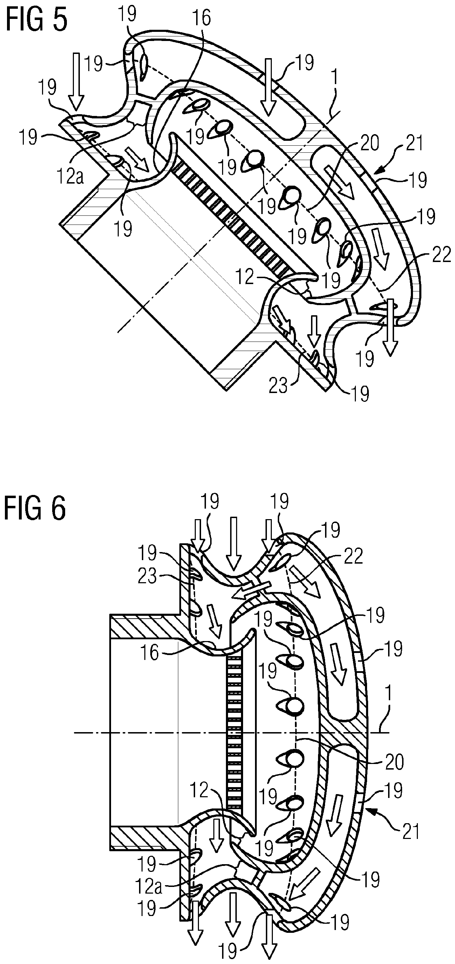

Die Figur 5 zeigt eine schräge Ausrichtung der Rotationsachse 1, wobei im Uhrzeigersinn eine Auslenkung um ca. 45° gezeigt ist. Nunmehr besteht die Möglichkeit, dass z. B. Partikel oder Feuchtigkeit durch Ventilationsöffnungen 19 der zweiten Kreisbahn 21 bzw. der vierten Kreisbahn 23 in das Innere der Ventilationsanordnung eindringen können. Partikel, oder Feuchtigkeit welche über Ventilationsöffnungen 19 der zweiten Kreisbahn 21 in den Bereich zwischen erster Schirmhaube 10 und zweiter Schirmhaube 13 eindringen, können dort an der äu-βeren Oberfläche der ersten Schirmhaube 10 herabgleiten und dort entweder über Ventilationsöffnungen 19 der dritten Kreisbahn 22 abtropfen oder bei einem weiteren Herabgleiten über den weiteren Ringspalt 12a, welcher zwischen der Mündungskante 11 der ersten Schirmhaube 10 sowie der zweiten Schirmhaube 13 gebildet ist, in Richtung des Anschlages 6 gleiten und von dort über Ventilationsöffnungen 19 der vierten Kreisbahn 23 aus der Ventilationsanordnung herausgeleitet werden. Weitere Ventilationsöffnungen 19 der vierten Kreisbahn 23 können gegebenenfalls einem Eintreten von Flüssigkeiten oder Partikeln dienen, wobei diese über die weitere Nut 16 in der Wandung des Ventilationskanals 2 um denselben herumgeleitet werden und am im Wesentlichen entgegengesetzten Ende über Ventilationsöffnungen 19 der vierten Kreisbahn 23, in die Umgebung abgleiten können.

Die Figur 6 zeigt eine horizontale Ausrichtung der Rotationsachse 1 der Ventilationsanordnung. Über Ventilationsöffnungen 19 der dritten Kreisbahn 22 können Partikel oder Flüssigkeiten in das Innere der Ventilationsanordnung gelangen. Diese können entweder über den Bereich zwischen Außenwandung der ersten Schirmhaube 10 sowie Innenwandung der zweiten Schirmhaube 13 abgeleitet werden und wiederum aus Ventilationsöffnungen 19 der dritten Kreisbahn 22 austreten. Alternativ kann auch ein Abgleiten von Partikeln oder Feuchtigkeit über den weiteren Ringspalt 12a zwischen der Mündungskante 11 der ersten Schirmhaube 10 sowie der zweiten Schirmhaube 13 erfolgen, wobei diese Flüssigkeiten bzw. Partikel in der weiteren Nut 16 außenmantelseitig um den Ventilationskanal 2 herum abgeleitet werden und von dort in den Bereich des Stoßes 18 gelangen, um von dort aus Ventilationsöffnungen 19 der vierten Kreisbahn 23 in die Umgebung der Ventilationsanordnung wieder abgegeben zu werden.

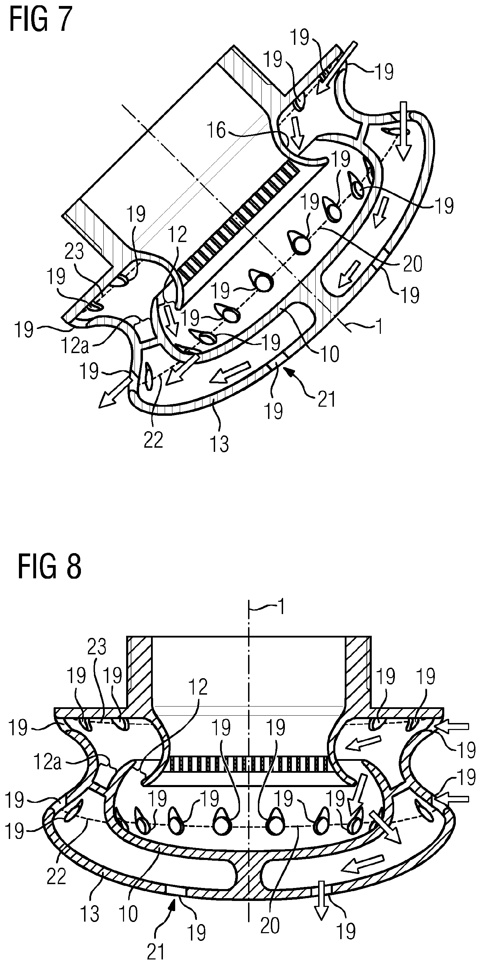

Die Figur 7 zeigt eine schräge Anordnung der Rotationsachse 11, wobei hierbei im Uhrzeigersinn, ausgehend von einer vertikalen Anordnung, eine Auslenkung von etwa 135° dargestellt ist. Wiederum können Partikel, die durch Ventilationsöffnungen 19 der dritten Kreisbahn 22 in den Bereich zwischen erster Schirmhaube 10 sowie zweiter Schirmhaube 13 gelangen, dort abgleiten und über im Wesentlichen entgegengesetzt dazu angeordnete Ventilationsöffnungen 19 der dritten Kreisbahn 22 auch wieder aus der Ventilationsanordnung austreten. Weiterhin ist die Möglichkeit gegeben, dass Ventilationsöffnungen 19 der vierten Kreisbahn 23 einen Eintritt von Flüssigkeiten oder anderen Fluiden oder Partikeln gewährleisten. Diese können dann z. B. in der weiteren Nut 16 des Ventilationskanals 2 um den Ventilationskanal 2 herumgeleitet werden und von dort in den konkav geformten Abschnitt, d. h. insbesondere in den Bereich der in sich geschlossen umlaufenden Nut 15 der ersten Schirmhaube 10 geleitet werden. Zum Übergang von der weiteren Nut 16 in den konkav geformten Abschnitt der ersten Schirmhaube 10 kann der Ringspalt 12 genutzt werden. Von dort kann über die auf der ersten Kreisbahn 20 liegenden Ventilationsöffnungen 19 einen Übertritt von Fremdstoffen in den Bereich zwischen der ersten Schirmhaube 10 sowie der zweiten Schirmhaube 13 erfolgen und von dort beispielsweise über Ventilationsöffnungen 19 der dritten Kreisbahn 22 in die Umgebung der Ventilationsanordnung übertreten.

Die Figur 8 zeigt eine vertikale Einbaulage der Ventilationsanordnung, wobei die Rotationsachse 1 einer Vertikalen angeordnet ist. Abweichend zur Lage wie in der Figur 4 gezeigt, ist nunmehr eine um 180° gedrehte Ausrichtung der Ventilationsanordnung vorgesehen (über Kopf). Über Ventilationsöffnungen 19 der vierten Kreisbahn 23 bzw. der dritten Kreisbahn 22 eintretenden Fluiden oder Partikeln ist die Möglichkeit gegeben, jeweils über Ventilationsöffnungen 19 der zweiten Kreisbahn 21 in die Umgebung austreten zu können. Dabei können über in der dritten Kreisbahn 22 befindliche Ventilationsöffnungen, eintretende Fluide oder Partikel sich beispielsweise auf direktem Wege zu den Ventilationsöffnungen 19 der zweiten Kreisbahn 21 bewegen. Bei den im Bereich der Ventilationsöffnungen 19 der vierten Kreisbahn 23 eintretenden Partikeln oder Fluiden ist die Möglichkeit gegeben, dass diese entweder über die weitere Nut 16 bzw. die Nut 15 der ersten Schirmhaube 10 (durch den Ringspalt 12) in den Bereich der Ventilationsöffnungen 19 der ersten Kreisbahn 20 geleitet werden, worauf von dort ein Übertritt in den Kanal zwischen erster Schirmhaube 10 und zweiter Schirmhaube 13 erfolgt. Von dort können die Partikel bzw. das Fluid über die Ventilationsöffnungen 19 der zweiten Kreisbahn 21 in die Umgebung der zweiten Schirmhaube 13 austreten. Gegebenenfalls können über die Ventilationsöffnungen 19 der vierten Kreisbahn 23 eintretende Fluide oder Partikel auch an einer konvexen Wandung der zweiten Schirmhaube 13 abtropfen und unmittelbar in den Kanal zwischen der ersten Schirmhaube 10 sowie der zweiten Schirmhaube 13 geleitet werden.

Wie anhand der Figuren 4 bis 8 zu erkennen ist, ist unabhängig von der Einbaulage der Ventilationsanordnung gewährleistet, dass ein unerwünschtes unmittelbares Eindringen von Fluiden bzw. Partikeln in die Mündungsöffnung 3 des Ventilationskanals 2 erschwert ist. Die Mündungsöffnung 3 des Ventilationskanals 2 ist durch die Formgebung der Wandung des Ventilationskanals 2 der ersten Schirmhaube 10 sowie der zweiten Schirmhaube 13 geschützt. Dabei ist aufgrund der Lage bzw. der Anordnung der Ventilationsöffnungen 19 auf den verschiedenen Kreisbahnen 20, 21, 22, 23 auch ein schwerkraftgetriebenes Leeren von Nuten bzw. Sammelpunkten für Partikel oder Fluide ermöglicht.

## Patentansprüche

1. Ventilationsanordnung für ein Gehäuse aufweisend einen Ventilationskanal (2) mit einer Mündungsöffnung (3) und einer die Mündungsöffnung (3) schirmenden ersten Schirmhaube (10), wobei der Ventilationskanal (2) sich zu der Mündungsöffnung (3) im Querschnitt erweitert und/oder verjüngt und die Mündungsöffnung (3) von der ersten Schirmhaube (10) unter Freilassung eines Spaltes (12) umgriffen ist,
**dadurch gekennzeichnet, dass**
die erste Schirmhaube (10) von einer zweiten Schirmhaube (13) umgriffen ist und außenmantelseitig am Ventilationskanal (2) und außenmantelseitig an der zweiten Schirmhaube (13) koaxial verlaufende Nuten (16, 17) angeordnet sind.

2. Ventilationsanordnung nach Anspruch 1,
**dadurch gekennzeichnet, dass**
die erste Schirmhaube (10) zum Umgriff der Mündungsöffnung (3) eine zur Querschnittsänderung des Ventilationskanals (2) im Bereich der Mündungsöffnung (3) gegensinnig gerichtete Querschnittsänderung aufweist.

3. Ventilationsanordnung nach Anspruch 1 oder 2,
**dadurch gekennzeichnet, dass**
einander zugewandte Mündungskanten (5, 11) von Ventilationskanal (2) und erster Schirmhaube (10) einander nicht hinterschneiden.

4. Ventilationsanordnung nach einem der Ansprüche 1 bis 3,
**dadurch gekennzeichnet, dass**
die zweite Schirmhaube (13) mit einer Wandung (4) des Ventilationskanals (2) verbunden ist, wobei die erste Schirmhaube (10) vor der Mündungsöffnung (3) schwebend an der zweiten Schirmhaube (13) abgestützt ist.

5. Ventilationsanordnung nach einem der Ansprüche 1 bis 4,
**dadurch gekennzeichnet, dass**
die erste Schirmhaube (10) innenmantelseitig koaxial verlaufend eine Nut (15) aufweist.

6. Ventilationsanordnung nach einem der Ansprüche 1 bis 5,
**dadurch gekennzeichnet, dass**
ein Nutgrund der Nut (16) des Ventilationskanals (2) in axialer Abfolge unterhalb der Nutgründe der Nuten (15, 17) der ersten und der zweiten Schirmhaube (10, 13) angeordnet ist, wobei unterhalb bezüglich der Achse der Austrittsrichtung der Mündungsöffnung (3) des Ventilationskanals (2) definiert ist.

7. Ventilationsanordnung nach einem der Ansprüche 1 bis 6,
**dadurch gekennzeichnet, dass**
ein Nutgrund der Nut (15) der ersten Schirmhaube (10) in axialer Abfolge sowohl oberhalb des Nutgrundes der Nut (16) des Ventilationskanals (2) als auch oberhalb des Nutgrundes der Nut (17) der zweiten Schirmhaube (13) angeordnet ist, wobei oberhalb bezüglich der Achse der Austrittsrichtung der Mündungsöffnung (2) des Ventilationskanals (2) definiert ist.

8. Ventilationsanordnung nach einem der Ansprüche 1 bis 7,
**dadurch gekennzeichnet, dass**
eine Ventilationsöffnung (3) zumindest in einer Nutflanke einer Nut (15, 17) beabstandet zum jeweiligen Nutengrund der jeweiligen Nut (15, 17) angeordnet ist.

9. Ventilationsanordnung nach einem der Ansprüche 1 bis 8,
**dadurch gekennzeichnet, dass**
im Ventilationskanal (2) ein Filter (9) angeordnet ist.

10. Ventilationsanordnung nach einem der Ansprüche 1 bis 9,
**dadurch gekennzeichnet, dass**
an einer Wandung des Ventilationskanals (2) ein Anschlag (6) für einen mantelseitigen Gewindegang, insbesondere außenmantelseitigen Gewindegang angeordnet ist.

11. Ventilationsanordnung nach Anspruch 10,
**dadurch gekennzeichnet, dass**
zumindest eine der Schirmhauben (10, 13) am Anschlag (6) abgestützt ist.

12. Ventilationsanordnung nach einem der Ansprüche 10 oder 11,
**dadurch gekennzeichnet, dass**
in einem Stoß (18) zwischen einer Schirmhaube (10, 13) und dem Anschlag (6) zumindest eine Ventilationsöffnung (19) angeordnet ist.

13. Ventilationsanordnung nach einem der Ansprüche 1 bis 12,
**dadurch gekennzeichnet, dass**
die Ventilationsanordnung additiv gefertigt ist.

14. Ventilationsanordnung nach einem der Ansprüche 1 bis 13,
**dadurch gekennzeichnet, dass**
die Ventilationsanordnung UV-stabil ist.

15. Vorrichtung, insbesondere Schaltschrank, aufweisend ein geschlossenes Gehäuse (24) mit einer Gehäusewand,
**dadurch gekennzeichnet, dass**
die Gehäusewand von einer Ventilationsanordnung gemäß einem der Ansprüche 1 bis 14 durchsetzt ist.

## Claims

1. Ventilation arrangement for a housing, having a ventilation channel (2) with a mouth opening (3) and a first shielding hood (10) shielding the mouth opening (3), wherein the ventilation channel (2) widens and/or narrows in cross section toward the mouth opening (3), and the mouth opening (3) is encompassed by the first shielding hood (10), leaving a gap (12) free,
**characterized in that**
the first shielding hood (10) is encompassed by a second shielding hood (13), and coaxially running grooves (16, 17) are arranged on the outer casing side of the ventilation channel (2) and on the outer casing side of the second shielding hood (13) .

2. Ventilation arrangement according to Claim 1,
**characterized in that**
the first shielding hood (10) for encompassing the mouth opening (3) has a cross-sectional change directed in the opposite direction to the cross-sectional change of the ventilation channel (2) in the region of the mouth opening (3).

3. Ventilation arrangement according to Claim 1 or 2,
**characterized in that**
mutually facing mouth edges (5, 11) of ventilation channel (2) and first shielding hood (10) do not undercut one another.

4. Ventilation arrangement according to one of Claims 1 to 3,
**characterized in that**
the second shielding hood (13) is connected to a wall (4) of the ventilation channel (2), wherein the first shielding hood (10) is supported on the second shielding hood (13) so as to be suspended in front of the mouth opening (3).

5. Ventilation arrangement according to one of Claims 1 to 4,
**characterized in that**
the first shielding hood (10) has a groove (15) running coaxially on the inner casing side.

6. Ventilation arrangement according to one of Claims 1 to 5,
**characterized in that**
a groove base of the groove (16) of the ventilation channel (2) is arranged in an axial sequence below the groove bases of the grooves (15, 17) of the first and the second shielding hood (10, 13), wherein below is defined with respect to the axis of the outlet direction of the mouth opening (3) of the ventilation channel (2).

7. Ventilation arrangement according to one of Claims 1 to 6,
**characterized in that**
a groove base of the groove (15) of the first shielding hood (10) is arranged in an axial sequence both above the groove base of the groove (16) of the ventilation channel (2) and above the groove base of the groove (17) of the second shielding hood (13), wherein above is defined with respect to the axis of the outlet direction of the mouth opening (2) of the ventilation channel (2).

8. Ventilation arrangement according to one of Claims 1 to 7,
**characterized in that**
a ventilation opening (3) is arranged at least in one groove flank of a groove (15, 17) at a distance from the respective groove base of the respective groove (15, 17).

9. Ventilation arrangement according to one of Claims 1 to 8,
**characterized in that**
a filter (9) is arranged in the ventilation channel (2).

10. Ventilation arrangement according to one of Claims 1 to 9,
**characterized in that**
a stop (6) for a casing-side thread, in particular outer-casing-side thread, is arranged on a wall of the ventilation channel (2).

11. Ventilation arrangement according to Claim 10,
**characterized in that**
at least one of the shielding hoods (10, 13) is supported on the stop (6).

12. Ventilation arrangement according to either of Claims 10 and 11,
**characterized in that**
at least one ventilation opening (19) is arranged in a joint (18) between a shielding hood (10, 13) and the stop (6).

13. Ventilation arrangement according to one of Claims 1 to 12,
**characterized in that**
the ventilation arrangement is manufactured additively.

14. Ventilation arrangement according to one of Claims 1 to 13,
**characterized in that**
the ventilation arrangement is UV-stable.

15. Device, in particular switch cabinet, having a closed housing (24) with a housing wall,
**characterized in that**
the housing wall is penetrated by a ventilation arrangement according to one of Claims 1 to 14.

## Revendications

1. Agencement de ventilation d'une enveloppe comportant un conduit (2) de ventilation ayant une ouverture (3) d'embouchure et une première hotte (10) de protection protégeant l'ouverture (3) d'embouchure, dans lequel le conduit (2) de ventilation s'élargit et/ou se rétrécit en section transversale par rapport à l'ouverture (3) d'embouchure et l'ouverture (3) d'embouchure est enveloppée par la première hotte (10) de protection en laissant libre un intervalle (12),
**caractérisé en ce que**
la première hotte (10) de protection est enveloppée d'une deuxième hotte (13) de protection et il est disposé des rainures (16, 17) s'étendant coaxialement sur le conduit (2) de ventilation du côté de la surface latérale extérieure et sur la deuxième hotte (13) de protection du côté de la surface latérale extérieure.

2. Agencement de ventilation suivant la revendication 1,
**caractérisé en ce que**
la première hotte (10) de protection a, pour envelopper l'ouverture (3) d'embouchure, une variation de la section transversale du conduit (2) de ventilation dirigée en sens contraire dans la partie de l'ouverture (3) d'embouchure.

3. Agencement de ventilation suivant la revendication 1 ou 2,
**caractérisé en ce que**
des bords (5, 11) d'embouchure tournés l'un vers l'autre du conduit (2) de ventilation et de la première hotte (10) de protection ne sont pas en contre-dépouille l'un avec l'autre.

4. Agencement de ventilation suivant l'une des revendications 1 à 3,
**caractérisé en ce que**
la deuxième hotte (13) de protection est reliée à une paroi (4) du conduit (2) de ventilation, dans lequel la première hotte (10) de protection est appuyée avant l'ouverture (3) d'embouchure de manière flottante sur la deuxième hotte (13) de protection.

5. Agencement de ventilation suivant l'une des revendications 1 à 4,
**caractérisé en ce que**
la première hotte (10) de protection a une rainure (15) s'étendant coaxialement du côté de la surface latérale intérieure.

6. Agencement de ventilation suivant l'une des revendications 1 à 5,
**caractérisé en ce qu'**
un fond de la rainure (16) du conduit (2) de ventilation est disposé en succession axiale en-dessous des fonds des rainures (15, 17) de la première et de la deuxième hottes (10, 13) de protection, dans lequel en-dessous est défini par rapport à l'axe de direction de sortie de l'ouverture (3) d'embouchure du conduit (2) de ventilation.

7. Agencement de ventilation suivant l'une des revendications 1 à 6,
**caractérisé en ce qu'**
un fond de la rainure (15) de la première hotte (10) de protection est disposé dans la succession axiale tant au-dessus du fond de la rainure (16) du conduit (2) de ventilation qu'également au-dessus du fond de la rainure (17) de la deuxième hotte (13) de protection, dans lequel au-dessus est défini par rapport à l'axe de la direction de sortie de l'ouverture (2) d'embouchure du conduit (2) de ventilation.

8. Agencement de ventilation suivant l'une des revendications 1 à 7,
**caractérisé en ce qu'**
une ouverture (3) de ventilation est disposée au moins dans un flanc d'une rainure (15, 17) à distance du fond respective de la rainure (15, 17) respective.

9. Agencement de ventilation suivant l'une des revendications 1 à 8,
**caractérisé en ce qu'**
un filtre (9) est monté dans le conduit (2) de ventilation.

10. Agencement de ventilation suivant l'une des revendications 1 à 9,
**caractérisé en ce que**
sur une paroi de conduit (2) de ventilation est disposée une butée (6) pour un filet de vis du côté de la surface latérale, en particulier un filet de vis du côté de la surface latérale extérieure.

11. Agencement de ventilation suivant la revendication 10,
**caractérisé en ce qu'**
au moins l'une des hottes (10, 13) de protection est appuyée sur la butée (6).

12. Agencement de ventilation suivant l'une des revendications 10 ou 11,
**caractérisé en ce qu'**
au moins une ouverture (19) de ventilation est disposée dans un about (18) entre une hotte (10, 13) de protection et la butée (6).

13. Agencement de ventilation suivant l'une des revendications 1 à 12,
**caractérisé en ce que**
l'agencement de ventilation est fabriqué additivement.

14. Agencement de ventilation suivant l'une des revendications 1 à 13,
**caractérisé en ce que**
l'agencement de ventilation est stable aux UV.

15. Installation, en particulier armoire de distribution comportant une enveloppe (24) fermée ayant une paroi d'enveloppe
**caractérisée en ce que**
la paroi d'enveloppe est traversée par un agencement de ventilation suivant l'une des revendications 1 à 14.
